# EUROPEAN PATENT APPLICATION

(11) **EP 4 624 550 A1**
(43) Date of publication of application: **01.10.2025**
(21) Application number: 23893842.7
(22) Date of filing: 21.11.2023
(51) Int. Cl.: C09K 11/61, C09K 11/64, C09K 11/02, H01L 25/075, H01L 33/50

(54) **RED FLUORESCENT COMPOSITION, RED FLUORESCENT FILM AND RED LED LIGHT SOURCE**

(30) Priority: 21.11.2022 CN 202211456736
(71) Applicant: Sichuan Wholelight Technology Development Co., Ltd, Chengdu, Sichuan 610000 (CN)
(72) Inventor: YANG, Xiaoqin, Chengdu, Sichuan 610000 (CN); ZENG, Sheng, Chengdu, Sichuan 610000 (CN); ZENG, Jiaoyang, Chengdu, Sichuan 610000 (CN); CHEN, Hua, Chengdu, Sichuan 610000 (CN); LI, Gang, Chengdu, Sichuan 610000 (CN); CHEN, Daorong, Chengdu, Sichuan 610000 (CN); ZENG, Xiaodong, Chengdu, Sichuan 610000 (CN)
(74) Representative: Cabinet Netter
(86) International application number: PCT/CN2023/133041
(87) International publication number: WO 2024/109752

(57) **Abstract**

The present application relates to the field of physiotherapy light source technology. Embodiments of the present application provide a red phosphor composition, a red phosphor film, and a red LED light source. The red phosphor composition includes: a first phosphor, a second phosphor, and a third phosphor. The first phosphor includes: a phosphor A, a phosphor B, and a phosphor D1 with different emission wavelengths. The second phosphor includes: a phosphor C, a phosphor D2, and a phosphor E1 with different emission wavelengths. The third phosphor includes: a phosphor D3, a phosphor E2, and a phosphor F with different emission wavelengths. In the spectral graph of the red light emitted by the red phosphor composition of this application, the peak exhibits a gentle profile. Within the wavelength range before and after the peak, the optical power of the red light remains close to that of the peak, ensuring consistent therapeutic effects across this broad band, thereby enhancing the overall therapeutic efficacy.

## Description

The present application claims the priority of the Chinese patent application filed with the Chinese Patent Office on November 21, 2022 with an application number 202211456736.0 and titled "RED PHOSPHOR COMPOSITION, RED PHOSPHOR FILM, AND RED LED LIGHT SOURCE", the entire contents of which are incorporated by reference in the present application.

### TECHNICAL FIELD

The present application relates to the technical field of physiotherapy light source technology, more particularly to a red phosphor composition, a red phosphor film, and a red LED light source.

### BACKGROUND

Red light physiotherapy is a method of using red light to irradiate the human body to improve the physiological condition of the human body. Red light has a certain penetration power for the skin and subcutaneous tissue. The warming effect of red light on muscles, subcutaneous tissue, etc. can accelerate blood circulation, promote metabolism and cell proliferation, and can play an anti to inflammatory, analgesic, massage, promote scar softening, and reduce scar contracture.

Traditional red light physiotherapy devices mostly use filtering methods to obtain red light, which has defects such as limited life of the filter liquid, low luminous efficiency, small irradiation area, flicker, complex structure, and light intensity and frequency cannot be modulated. LED light sources have become artificial light sources with wide application in the medical and beauty fields due to their advantages such as high efficiency, narrow band, direct current, energy saving, and environmental protection.

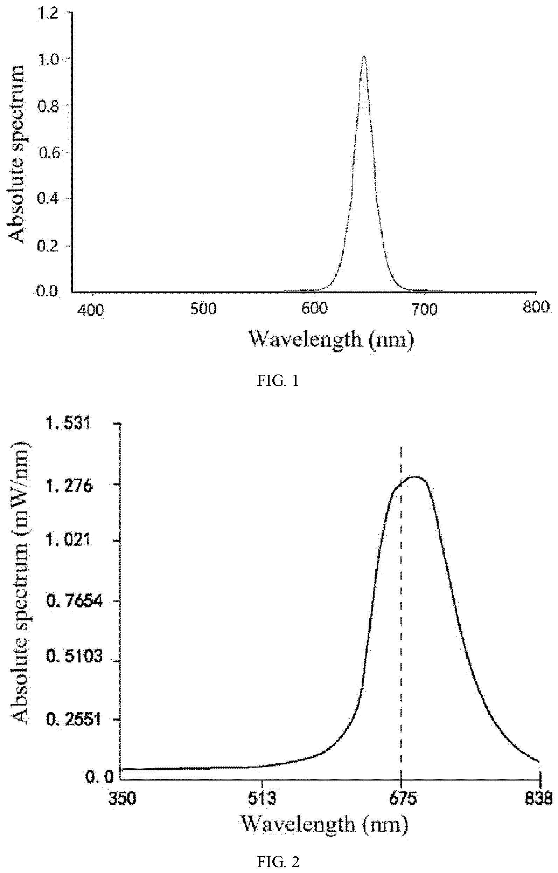

FIG. 1 is a spectrum diagram of a red LED light source in the prior art. As shown in FIG. 1, the spectrum diagram of the red LED light source in the prior art has a steep and narrow peak shape, and the optical power of the red light before and after the peak decreases rapidly with the wavelength. When the red LED light source in the prior art is used for physiotherapy, only the red light in the narrow band before and after the peak can produce the physiotherapy effect. The effective band of physiotherapy is too narrow, and the physiotherapy effect of red light cannot be further improved.

### TECHNICAL PROBLEMS

The purpose of the present application is to provide a red phosphor composition, a red phosphor film, and a red LED light source to solve the technical problem that the red LED light source in the prior art has a steep and narrow peak shape in the spectrum graph, and the optical power of the red light before and after the peak decreases rapidly with the wavelength, which leads to a narrow effective band for physiotherapy and poor physiotherapy effect.

### TECHNICAL SOLUTIONS

In order to achieve the above application purpose, the first aspect of embodiments of the present application provides a red phosphor composition. The red phosphor composition in embodiments of the present application comprises: a first phosphor, a second phosphor, and a third phosphor.

The first phosphor comprises: a phosphor A, a phosphor B, and a phosphor D1.

The second phosphor comprises: a phosphor C, a phosphor D2, and a phosphor E1.

The third phosphor comprises: a phosphor D3, a phosphor E2, and a phosphor F.

An emission wavelength of the phosphor A is 600 nm to 640 nm.

An emission wavelength of the phosphor B is 650 nm to 660 nm.

An emission wavelength of the phosphor C is 670 nm to 700 nm.

Emission wavelengths of the phosphor D1, the phosphor D2, and the phosphor D3 are independently 710 nm to 730 nm.

Emission wavelengths of the phosphor E1, the phosphor E2, and the phosphor F are independently greater than 730 nm and less than or equal to 800 nm.

The red phosphor composition of the embodiments of the present application comprises different phosphors with emission wavelengths dispersed in 600 nm to 800 nm in the first phosphor, the second phosphor, and the third phosphor, respectively, so that the red phosphor composition of the embodiments of the present application is excited to produce a wide spectrum of red light, and the spectrum of the red light includes a flat and wide peak in the wavelength range of 600 nm to 800 nm. In the wide band before and after the peak, the red light has similar light power and energy density and all can produce a physiotherapy effect during physiotherapy. This band is the effective band for physiotherapy. Thus, the effective band of red light physiotherapy produced by the red phosphor composition of the embodiment of the present application is wide and has a good physiotherapy effect.

In a second aspect of embodiments of the present application, a red phosphor film is provided, and the red phosphor film of embodiments of the present application comprises: a first phosphor film, a second phosphor film, and a third phosphor film.

The first phosphor film comprises: a first film-forming material, and the first phosphor contained in the red phosphor composition according to above embodiments and dispersed in the first film-forming material.

The second phosphor film comprises: a second film-forming material, and a second phosphor contained in the red phosphor composition according to above embodiments and dispersed in the second film-forming material.

The third phosphor film comprises: a third film-forming material, and a third phosphor contained in the red phosphor composition according to above embodiments and dispersed in the third film-forming material.

The red phosphor film of embodiments of the present application includes the red phosphor composition of the above embodiments of the present application, so that the red phosphor film of the embodiments of the present application is excited to produce a wide spectrum of red light, the peak of the red light is flat and the band range is wide, the red light has similar light power and energy density and all can produce a physiotherapy effect during physiotherapy, so the red light physiotherapy effect produced by the red phosphor film of the embodiments of the present application is good.

In the third aspect of embodiments of the present application, a red LED light source is provided. The red LED light source of embodiments of the present application includes a light-emitting unit, the light-emitting unit comprises: a chip, and a red phosphor film arranged on an optical path of the chip, and the red phosphor film is the red phosphor film provided by the above embodiments of the application embodiment.

The red LED light source of embodiments of the present application generates excitation light through the chip, which excites the red phosphor composition contained in the red phosphor film to generate red light. The red light has a wide and flat peak, and the peak is an effective band for physiotherapy, so that the red light generated by the red LED light source of the embodiments of the present application has a good physiotherapy effect. In addition, the red LED light source of the embodiments of the present application adjusts the red light generated by adjusting the emission wavelength of the red phosphor composition, so that the red light has the characteristics of a wide spectrum and a flat peak, a simple operation method, good repeatability, and a high product yield.

### BRIEF DESCRIPTION OF THE DRAWINGS

In order to more clearly illustrate the technical scheme in the embodiment of the present application, the following will briefly introduce the drawings required to be used in the embodiment or the prior art description. Obviously, the drawings described below are only some embodiments of the present application. For ordinary technicians in this field, other drawings can be obtained based on these drawings without creative work.
FIG. 1 is a spectrum diagram of a red LED light source in the prior art;
FIG. 2 is a spectrum diagram of a red LED light source provided by Example C1;
FIG. 3 is a spectrum diagram of a red LED light source provided by Example C2;
FIG. 4 is a spectrum diagram of a red LED light source provided by Example C3;
FIG. 5 is a spectrum diagram of a red LED light source provided by Example C4;
FIG. 6 is a spectrum diagram of a red LED light source provided by Example C5;
FIG. 7 is a spectrum diagram of a red LED light source provided by Example C6;
FIG. 8 is a spectrum diagram of a red LED light source provided by Example C7;
FIG. 9 is a spectrum diagram of a red LED light source provided by Example C8;
FIG. 10 is a spectrum diagram of a red LED light source provided by Example C9;
FIG. 11 is a spectrum diagram of a red LED light source provided by Comparative Example C1;
FIG. 12 is a spectrum diagram of a red LED light source provided by Comparative Example C2; and
FIG. 13 is a spectrum diagram of a red LED light source provided by Comparative Example C3.

### DETAILED DESCRIPTION OF THE EMBODIMENTS

To clarify the technical problems to be solved by the present application, technical solutions, and beneficial effects, the present application is further described in detail in combination with the embodiments below. It should be understood that the specific embodiments described herein are only used to explain the present application and are not used to limit the present application.

In a first aspect of embodiments of the present application, a red phosphor composition is provided. The red phosphor composition of the embodiments of the present application comprises: a first phosphor, a second phosphor, and a third phosphor.

The first phosphor comprises: a phosphor A, a phosphor B, and a phosphor D1; an emission wavelength of the phosphor A is 600 nm to 640 nm, and may optionally be 610 nm to 640 nm; an emission wavelength of the phosphor B is 650 nm to 660 nm; and an mission wavelength of the phosphor D1 is 710 nm to 730 nm.

The second phosphor comprises: a phosphor C, a phosphor D2, and a phosphor E1; an emission wavelength of the phosphor C is 670 nm to 700 nm, an emission wavelength of the phosphor D2 is 710 nm to 730 nm; and an emission wavelength of the phosphor E1 is greater than 730 nm and less than or equal to 800 nm.

The third phosphor comprises: a phosphor D3, a phosphor E2, and a phosphor F. An emission wavelength of the phosphor D3 is 710 nm to 730 nm; and emission wavelengths of the phosphor E2 and the phosphor F are independently greater than 730 nm and less than or equal to 800 nm.

The red phosphor composition of the embodiments of the present application is excited to produce a wide spectrum of red light by using the first phosphor, the second phosphor, and the third phosphor whose emission wavelengths are dispersed in the range of 600 nm to 800 nm. The spectrum of the red light includes a flat peak in the range of 600 nm to 800 nm. In the wide band before and after the peak, the red light has similar light power and energy density and all can produce a physiotherapy effect during physiotherapy. This band is the effective band for physiotherapy. Thus, the effective band of red light physiotherapy produced by the red phosphor composition of the embodiment of the present application is wide and has a good physiotherapy effect.

It should be noted that in embodiments of the present application, the band refers to the wavelength range of the red light, and the effective band refers to the wavelength range of the red light that can produce physiotherapy effects.

It can be understood that the emission wavelength of the phosphor refers to the wavelength at the main peak in the spectrum of the light generated by the phosphor when excited by photons.

In some embodiments, at least one of the first phosphor, the second phosphor, and the third phosphor contained in the red phosphor composition of the present application is provided separately from other two phosphors. In an exemplary embodiment, the first phosphor, the second phosphor, and the third phosphor are provided separately. By providing at least one of the first phosphor, the second phosphor, and the third phosphor separately from other two phosphors, the mass ratio of the first phosphor, the second phosphor, and the third phosphor can be flexibly adjusted according to the luminous effect.

In a further embodiment, the emission wavelength of the phosphor A may be 630 nm, the emission wavelength of the phosphor B may be 660 nm, and the emission wavelength of the phosphor C may be 679 nm. The emission wavelengths of the phosphor D1, the phosphor D2, and the phosphor D3 may all be 720 nm. The emission wavelengths of the phosphor E1 and the phosphor E2 may all be 738 nm to 742 nm, specifically be 740 nm, and the emission wavelength of the phosphor F may be 793 nm to 797 nm, specifically be 795 nm.

In some embodiments, the first phosphor, the second phosphor, and the third phosphor may comprise at least one of a nitride red powder and a fluoride red powder. Specifically, the phosphor A, the phosphor B, the phosphor C, the phosphor D1, the phosphor D2, the phosphor D3, the phosphor E1, the phosphor E2, and the phosphor F may respectively comprise at least one of the nitride red powder and the fluoride red powder.

In an exemplary embodiment, the phosphor A, the phosphor B, the phosphor C, the phosphor D1, the phosphor D2, the phosphor D3, the phosphor E1, the phosphor E2, and the phosphor F may be independently but not limited to (Ca,Sr)AlSiN₃ (calcium strontium aluminum silicon nitride, 1113) or K₂SiF₆: Mn⁴⁺ (Manganese(IV)-doped potassium hexafluorosilicate). In addition, the phosphors of various emission wavelengths such as the phosphor A, the phosphor B, the phosphor C, the phosphor D1, the phosphor D2, the phosphor D3, the phosphor E1, the phosphor E2, and the phosphor F can be directly purchased commercially according to the emission wavelength.

It should be noted that the specific number of compounds included in any of the phosphor A, the phosphor B, the phosphor C, the phosphor D1, the phosphor D2, the phosphor D3, the phosphor E1, the phosphor E2, or the phosphor F is not limited, and may include only a single pure compound or a mixture of multiple compounds.

It can be understood that the specific emission wavelengths of the phosphor D1 contained in the first phosphor, the phosphor D2 contained in the second phosphor, and the phosphor D3 contained in the third phosphor may be the same, for example, the emission wavelengths of the phosphor D1, the phosphor D2, and the phosphor D3 are all 720 nm. The emission wavelengths of the phosphor D1, the phosphor D2, and the phosphor D3 may also be different, for example, the emission wavelengths of the phosphor D1, the phosphor D2, and the phosphor D3 are 715 nm, 720 nm, and 725 nm, respectively. When the emission wavelengths of the phosphor D1, the phosphor D2, and the phosphor D3 are the same, the phosphor D1, the phosphor D2, and the phosphor D3 can be the same substance, for example, the phosphor D1, the phosphor D2, and the phosphor D3 are all (Ca,Sr)AlSiN₃. The phosphor D1, the phosphor D2, and the phosphor D3 can also be different substances, for example, the phosphor D1 is (Ca,Sr)AlSiN₃, and the phosphor D2 and the phosphor D3 are both K₂SiF₆: Mn⁴⁺. Similarly, the specific emission wavelengths of the phosphor E1 and the phosphor E2 can be the same or different. When the emission wavelengths of the phosphor E1 and the phosphor E2 are the same, the phosphor E1 and the phosphor E2 can be the same substance or different substances.

In some embodiments, a mass ratio of the phosphor A, the phosphor B, and the phosphor D1 in the first phosphor can be controlled to be (3 to 25) : (3 to 35) : (5 to 50), optionally be (5 to 20) : (5 to 25) : (10 to 40), and further optionally be (5 to 15) : (5 to 20) : (10 to 30).

In some embodiments, a mass ratio of the phosphor C, the phosphor D2, and the phosphor E1 in the second phosphor can be controlled to be (7 to 35) : (7 to 40) : (10 to 50), optionally be (10 to 30) : (10 to 35) : (15 to 40),, and further optionally be (10 to 25) : (10 to 30) : (20 to 40).

In some embodiments, a mass ratio of the phosphor D3, the phosphor E2, and the phosphor F in the third phosphor can be controlled to be (10 to 40) : (10 to 40) : (15 to 50), optionally be (12 to 35) : (12 to 35) : (15 to 40), further optionally be (15 to 30) : (15 to 30) : (15 to 35).

By controlling the mass ratio of the phosphor A, the phosphor B, and the phosphor D1, the mass ratio of the phosphor C, the phosphor D2, and the phosphor E1, and the mass ratio of the phosphor D3, the phosphor E2, and the phosphor F within the above ranges, the light intensity, peak flatness, peak wavelength, and peak width of the red light generated by the red phosphor composition of the embodiments of the present application can be adjusted, so that the peak in the spectrum of the red light is flatter and wider, so as to further broaden the effective wavelength of the red light and improve the physiotherapy effect of the red light. Moreover, within the above ranges, the ratio of one or more of the phosphors can be adjusted to increase the light power of one or more specific wavelengths in the red light, so that the light power of the specific wavelength is prominent over other wavelengths, so as to improve the phototherapy effect or function of the red light of the wavelength. For example, by adjusting the ratio of the phosphors, the red light generated by the red phosphor composition at a wavelength of 650 nm has a higher light power than the red light at other wavelengths, so that the red light generated by the red phosphor composition of the embodiments of the present application is more conducive to the healing of human wound tissue.

In some embodiments, particle sizes of the first phosphor, the second phosphor, and the third phosphor can be controlled to be independently less than or equal to 50 µm, optionally 5 µm to 50 µm, and further optionally 10 µm to 50 µm. The particle sizes of the first phosphor, the second phosphor, and the third phosphor are controlled within this range, so that the particles of the first phosphor, the second phosphor, and the third phosphor have a larger specific surface area, thereby improving the luminous efficiency. Moreover, when the first phosphor, the second phosphor, and the third phosphor are formed into a film with a film-forming material, the particles of the first phosphor, the second phosphor, and the third phosphor have better compatibility with the film-forming material, thereby making the film thickness thinner.

The second aspect of the embodiments of the present application provides a red phosphor film, and the red phosphor film of the embodiments of the present application comprises: a first phosphor film, a second phosphor film, and a third phosphor film. The first phosphor film comprises: a first film-forming material, and a first phosphor contained in the red phosphor composition of the above-mentioned embodiments of the application dispersed in the first film-forming material. The second phosphor film comprises: a second film-forming material, and a second phosphor contained in the red phosphor composition of the above-mentioned embodiment of the application dispersed in the second film-forming material. The third phosphor film comprises a third film-forming material, and a third phosphor contained in the red phosphor composition of the above-mentioned embodiment of the application dispersed in the third film-forming material.

The red phosphor film of the embodiments of the present application comprises the red phosphor composition of the above-mentioned embodiments of the present application, so that the red phosphor film of the embodiments of the present application can be excited by photons to produce a wide spectrum of red light, and in the spectrum of the red light, the peak shape is flat in a wide band before and after the peak, and the band is an effective band. The red light within the band has similar light power and energy density, and all can produce a physiotherapy effect. Therefore, the effective band of the red light physiotherapy generated by the red phosphor film of the embodiments of the present application is wide, and the physiotherapy effect is good.

In some embodiments, the first phosphor film, the second phosphor film, and the third phosphor film in embodiments of the present application can be stacked in sequence, or can be separately arranged. For example, in some specific exemplary embodiment, the first phosphor film, the second phosphor film, and the third phosphor film are separately arranged. In other exemplary embodiments, the first phosphor film and the second phosphor film are stacked to form a fourth phosphor film containing a double film layer, and are arranged separately from the third phosphor film.

The first phosphor film, the second phosphor film, and the third phosphor film separately include the first phosphor, the second phosphor, and the third phosphor, so that when the red phosphor composition is used, it is not necessary to mix the first phosphor, the second phosphor, and the third phosphor in proportion, and the proportion of the first phosphor, the second phosphor, and the third phosphor can be flexibly adjusted according to demand when preparing the red phosphor film. Moreover, the film thickness of the first phosphor film, the second phosphor film, and the third phosphor film and the concentration of the phosphor can be adjusted respectively to further optimize the luminous efficiency.

In some embodiments, the first film-forming material, the second film-forming material, and the third film-forming material can independently include at least one of a silica gel and an epoxy resin. These materials, such as the silica gel, have excellent properties such as good light transmittance, atmospheric aging resistance and ultraviolet aging resistance, so that the red phosphor film has good light transmittance and is not easy to turn yellow due to aging during use.

In addition, the first film-forming material, the second film-forming material, and the third film-forming material may be the same, for example, in a specific exemplary embodiment, the first film-forming material, the second film-forming material, and the third film-forming material are all silica gel. The first film-forming material, the second film-forming material, and the third film-forming material may also be different, for example, in other specific exemplary embodiments, the first film-forming material is silica gel, while the second film-forming material and the third film-forming material are both epoxy resin.

In some embodiments, a mass ratio of the first phosphor in the first phosphor film, the second phosphor in the second phosphor film, and the third phosphor in the third phosphor film may be controlled to be (5 to 30): (10 to 40): (15 to 60), optionally be (7 to 25): (12 to 30): (17 to 50), and further optionally be (10 to 20): (15 to 25): (20 to 40). By controlling the mass ratio of the first phosphor, the second phosphor, and the third phosphor within this range, the flatness of the peak shape before and after the peak in the spectrum of the red light generated by the red phosphor film of the embodiments of the present application is further improved, the effective band of red light physiotherapy is expanded, and the physiotherapy effect is improved.

In some embodiments, any of the first phosphor film, the second phosphor film, and the third phosphor film can be a single film, so that the film thickness of the first phosphor film, the second phosphor film, and the third phosphor film can be thinner. In a further embodiment, the film thickness of the first phosphor film, the second phosphor film, and the third phosphor film can also be controlled to be sub-millimeter level, such as 0.06 mm to 0.60 mm, to improve the luminous efficiency.

In some embodiments, the first phosphor film comprises a plurality of single film layers, and the plurality of single film layers are stacked and combined to form a composite film. In an exemplary embodiment, the first phosphor film is a composite film formed by a film layer A, a film layer B, and a film layer D1. The film layer A contains the phosphor A, the film layer B contains the phosphor B, and the film layer D1 contains the phosphor D1. During preparation, the film layer A, the film layer B, and the film layer D1 can be prepared separately by the film pressing method, and then the film layer A, the film layer B, and the film layer D1 are stacked in sequence, and vacuum pressed to form the first phosphor film. Alternatively, the film layer A can also be formed by spray coating, and then the film layer B is spray coated on the film layer A, and finally the film layer D1 is spray coated again on the basis of the film layer A and the film layer B, so that the film layer A, the film layer B, and the film layer D1 are composited to form the first phosphor film.

In some embodiments, the second phosphor film comprises a plurality of single film layers, and the plurality of single film layers are stacked and combined to form the second phosphor film. The combination mode between the plurality of single film layers in the second phosphor film can be the same as the combination mode of the plurality of single film layers in the first phosphor film.

In some embodiments, the third phosphor film comprises a plurality of single film layers, and the plurality of single film layers are stacked and combined to form the third phosphor film. The combination mode between the plurality of single film layers in the third phosphor film can be the same as the combination mode of the plurality of single film layers in the first phosphor film.

The first phosphor film, the second phosphor film, and the third phosphor film are respectively formed by compounding a plurality of single film layers. When preparing the first phosphor film, the second phosphor film, and the third phosphor film, the mass ratio and concentrations of the phosphors can be flexibly controlled, and the red light generated by the red phosphor film of the embodiments of the present application can be adjusted as needed. For example, the mass ratio and concentrations of the phosphor A, the phosphor B, and the phosphor D1 in the first phosphor can be controlled.

In some embodiments, the concentration of the first phosphor in the first phosphor film can be controlled to be 40% to 87%, optionally be 50% to 80%, and further optionally be 60% to 75%. The concentration of the first phosphor is the proportion of the mass of the first phosphor in the total mass of the first phosphor and the first film-forming material.

In some embodiments, the concentration of the second phosphor in the second phosphor film can be controlled to be 30% to 87%, optionally be 40% to 80%, and further optionally be 60% to 75%. The concentration of the second phosphor is the proportion of the mass of the second phosphor in the total mass of the second phosphor and the second film-forming material.

In some embodiments, the concentration of the third phosphor in the third phosphor film can be controlled to be 30% to 87%, optionally be 45% to 80%, and further optionally be 60% to 75%. The concentration of the third phosphor is the proportion of the mass of the third phosphor in the total mass of the third phosphor and the third film-forming material.

The concentrations of the first phosphor, the second phosphor, and the third phosphor have a significant effect on the optical power of the red light generated by the red phosphor film of the embodiments of the present application. The greater the concentration, the greater the optical power of the red light generated. By controlling the concentration of the first phosphor, the second phosphor, and the third phosphor within this range, the light power of the red light emitted by the red phosphor film can be adjusted to improve the physiotherapy effect of the red light.

It can be understood that the red phosphor film of the embodiments of the present application can be formed by a film pressing method and/or a spray coating method.

In some embodiments, the red phosphor film of the embodiments of the present application is formed by a film pressing method, and the film thickness of any one of the first phosphor film, the second phosphor film, and the third phosphor film can be controlled to be 0.06 mm to 0.6 mm.

In some embodiments, the red phosphor film of the embodiments of the present application is formed by a spray coating method, and the film thickness of any one of the first phosphor film, the second phosphor film, and the third phosphor film can be controlled to be 0.001 mm to 0.01 mm, optionally be 0.002 mm to 0.006 mm, and further optionally be 0.002 mm to 0.003 mm.

The thickness of the red phosphor film in embodiments of the present application is controlled within this range, which is almost close to the particle size of the red phosphor composition particles, so that after the red phosphor film and the chip are made into a light source, the refraction of the excitation light generated by the chip in the red phosphor film can be further reduced, so that the excitation light can reach the surface of the red phosphor composition particles to the maximum extent, so as to promote the red phosphor composition to be excited to produce red light to the greatest extent, thereby improving the luminous efficiency. It should be noted that the thicknesses of the first phosphor film, the second phosphor film, and the third phosphor film in the red phosphor film can be the same or different, and those skilled in the art can adjust the film thickness as needed or according to the luminous efficiency.

In a third aspect of embodiments of the present application, a red LED light source is provided. The red LED light source in embodiments of the present application includes a light-emitting unit, and the light-emitting unit includes a chip and a red phosphor film arranged on an optical path of the chip. The red phosphor film is the red phosphor film in the embodiments of the present application mentioned above. In order to save space, the red phosphor film will not be described here.

The red LED light source provided in the embodiments of the present application generates excitation light through the chip, and excites the red phosphor film arranged on the light output path of the chip to generate a wide spectrum of red light. In the spectrum of the red light, the peak shape is flat in a wide band before and after the peak, and the red light within the band has similar light power and energy density, and all can produce a physiotherapy effect. This band is an effective band for physiotherapy. The red LED light source of the embodiments of the present application excites the red phosphor film through the chip, and the generated red light has a wide effective band and good physiotherapy effect.

In some embodiments, the red LED light source of the embodiments of the present application comprises a plurality of light-emitting units, which may specifically comprise three light-emitting units, namely, a first light-emitting unit, a second light-emitting unit, and a third light-emitting unit. The first light-emitting unit comprises: a first chip, and the first phosphor film as described in the above arranged on an optical path of the first chip. The second light-emitting unit comprises: a second chip, and the second phosphor film as described in the above arranged on an optical path of the second chip. The third light-emitting unit comprises: a third chip, and the third phosphor film as described in the above arranged on an optical path of the third chip. Alternatively, in some other embodiments, the red LED light source of the embodiments of the present application may also specifically comprise two light-emitting units, namely, a fourth light-emitting unit and a fifth light-emitting unit. The fourth light-emitting unit comprises a fourth chip and the fourth phosphor film as described in the above, and the fifth light-emitting unit comprises a fifth chip, and the third phosphor film as described in the above.

By separately making the first phosphor film, the second phosphor film, and the third phosphor film into different light-emitting units, the red lights generated by different light-emitting units are composited to form a red light with a wide effective band and good physiotherapy effect. Moreover, the wavelength range and flatness of the peak of the red light generated by the red LED light source can be flexibly adjusted by adjusting the peak of the red light generated by different light-emitting units, so that the peak shape in the band before and after the peak is flatter, and the light power and energy density of the red light in this band are closer.

In some embodiments, any of the first phosphor film, the second phosphor film, and the third phosphor film is composited by a plurality of single film layers, and the plurality of single film layers are arranged in order from small to large in refractive index, that is, single film layer with a smaller refractive index is arranged closer to the chip, and a single film layer with a larger refractive index is arranged further away from the chip. By arranging the film layer with a smaller refractive index closer to the chip, the propagation of light in the light source is from the optically sparse medium to the optically dense medium, which avoids the problem that the light cannot be emitted due to the incident angle of the light being greater than the critical angle of total reflection when the light propagates from the optically dense medium to the optically sparse medium, thereby causing the red LED light source to have low brightness.

In some embodiments, the emission wavelength of any one of the first chip, the second chip, and the third chip can be controlled to be 440 nm to 475 nm, optionally be 440 nm to 460 nm, and further optionally be 452 nm to 455 nm. By controlling the emission wavelength of the chip within this range, the optical power of 435 nm to 440 nm blue light can be reduced to reduce the damage of 435 nm to 440 nm blue light to the retina. It is understandable that the emission wavelengths of the first chip, the second chip, and the third chip can be the same, for example, the emission wavelengths of the first chip, the second chip, and the third chip are all 452 nm, and the emission wavelengths of the first chip, the second chip, and the third chip can also be different, for example, the emission wavelengths of the first chip, the second chip, and the third chip are 452 nm, 455 nm, and 458 nm respectively, which can be set according to needs of those skilled in the art.

It is understandable that the emission wavelength of the chip refers to the wavelength at the main peak in the spectrum of the light generated by the chip when being excited by a current.

In some embodiments, the red phosphor film in the red LED light source of the embodiments of the present application is prepared by a film pressing method, and the film thickness of any one of the first phosphor film, the second phosphor film, and the third phosphor film can be controlled to be 0.06mm to 0.6mm, and the emission wavelength of any one of the first chip, the second chip, and the third chip is 440 nm to 475 nm. In the first phosphor film, the concentration of the first phosphor is 40% to 87%, and the mass ratio of the phosphor A, the phosphor B, and the phosphor D1 in the first phosphor is (3 to 25): (3 to 35): (5 to 50). In the second phosphor film, the concentration of the second phosphor is 40% to 87%, and the mass ratio of the phosphor C, the phosphor D2, and the phosphor E1 in the second phosphor is (7 to 35): (7 to 40): (10 to 50). In the third phosphor film, the concentration of the third phosphor is 40% to 87%, and the mass ratio of the phosphor D3, the phosphor E2, and the phosphor F in the third phosphor is (10 to 40): (10 to 40): (15 to 50).

In a further embodiment, the emission wavelengths of the first chip, the second chip, and the third chip can be controlled to be 440 nm to 460 nm. The concentration of the first phosphor in the first phosphor film is 50% to 80%, and the mass ratio of the phosphor A, the phosphor B, and the phosphor D1 in the first phosphor is (5 to 20): (5 to 25): (10 to 40). The concentration of the second phosphor in the second phosphor film is 50% to 80%, and the mass ratio of the phosphor C, the phosphor D2, and the phosphor E1 in the second phosphor is (10 to 30): (10 to 35): (15 to 40). The concentration of the third phosphor in the third phosphor film is 50% to 80%, and the mass ratio of the phosphor D3, the phosphor E2, and the phosphor F in the third phosphor is (12 to 35): (12 to 35): (15 to 40).

In a further embodiment, the emission wavelengths of the first chip, the second chip, and the third chip can be controlled to be 452 nm to 455 nm. The concentration of the first phosphor in the first phosphor film is 60% to 75%, and the mass ratio of the phosphor A, the phosphor B, and the phosphor D1 in the first phosphor is (5 to 15): (5 to 20): (10 to 30). The concentration of the second phosphor in the second phosphor film is 60% to 75%, and the mass ratio of the phosphor C, the phosphor D2, and the phosphor E1 in the second phosphor is (10 to 25): (10 to 30): (20 to 40). The concentration of the third phosphor in the third phosphor film is 60% to 75%, and the mass ratio of the phosphor D3, the phosphor E2, and the phosphor F in the third phosphor is (15 to 30): (15 to 30): (15 to 35).

In some embodiments, the red phosphor film of the red LED light source of the embodiments of the present application is prepared by a spray coating method, and the film thickness of any one of the first phosphor film, the second phosphor film, and the third phosphor film can be controlled to be 0.001mm to 0.01mm, and the emission wavelength of any one of the first chip, the second chip, and the third chip is 440 nm to 475 nm. The concentration of the first phosphor in the first phosphor film is 40% to 87%, and the mass ratio of the phosphor A, the phosphor B, and the phosphor D1 in the first phosphor is (3 to 25): (3 to 35): (5 to 50). The concentration of the second phosphor in the second phosphor film is 30% to 85%, and the mass ratio of the phosphor C, the phosphor D2, and the phosphor E1 in the second phosphor is (7 to 35): (7 to 40): (10 to 50). The concentration of the third phosphor in the third phosphor film is 30% to 85%, and the mass ratio of the phosphor D3, the phosphor E2, and the phosphor F in the third phosphor is (10 to 40): (10 to 40): (15 to 50).

In a further embodiment, the thicknesses of the first phosphor film, the second phosphor film, and the third phosphor film can be controlled to be 0.002 mm to 0.006 mm, and the emission wavelengths of the first chip, the second chip, and the third chip are all 440 nm to 460 nm. The concentration of the first phosphor in the first phosphor film is 50% to 80%, and the mass ratio of the phosphor A, the phosphor B, and the phosphor D1 in the first phosphor is (5 to 20): (5 to 25): (10 to 40). The concentration of the second phosphor in the second phosphor film is 40% to 75%, and the mass ratio of the phosphor C, the phosphor D2, and the phosphor E1 in the second phosphor is (10 to 30): (10 to 35): (15 to 40). The concentration of the third phosphor in the third phosphor film is 45% to 75%, and the mass ratio of the phosphor D3, the phosphor E2, and the phosphor F in the third phosphor is (12 to 35): (12 to 35): (15 to 40).

In a further embodiment, the thickness of the first phosphor film, the second phosphor film, and the third phosphor film can be controlled to be 0.002 mm to 0.003 mm, and the emission wavelengths of the first chip, the second chip, and the third chip are all 452 nm to 455 nm. The concentration of the first phosphor in the first phosphor film is 60% to 75%, and the mass ratio of the phosphor A, the phosphor B, and the phosphor D1 in the first phosphor is (5 to 15): (5 to 20): (10 to 30). The concentration of the second phosphor in the second phosphor film is 60% to 75%, and the mass ratio of the phosphor C, the phosphor D2, and the phosphor E1 in the second phosphor is (10 to 25): (10 to 30): (20 to 40). The concentration of the third phosphor in the third phosphor film is 60% to 69%. In the third phosphor, the mass ratio of the phosphor D3, the phosphor E2, and the phosphor F is (15 to 30): (15 to 30): (15 to 35).

In order to make the details and operations of the above embodiments of the present application clearly understood by those skilled in the art, and to demonstrate the significant improvement in the performance of the red phosphor composition, the red phosphor film, and the red LED light source in embodiments of the present application, the above technical solutions are illustrated by the following multiple examples.

### 1. Examples of red phosphor compositions

### Example A1 to Example A9

Examples A1 to Example A9 respectively provide a red phosphor composition. The red phosphor composition of Example A1 to Example A9 comprises: a first phosphor, a second phosphor, and a third phosphor that are separately provided, and particle sizes of the first phosphor, the second phosphor, and the third phosphor are 10 µm to 25 µm.

The first phosphor comprises: a phosphor A, a phosphor B, and a phosphor D1. The phosphor A is (Ca,Sr)AlSiN₃ with an emission wavelength of 630 nm, the phosphor B is (Ca,Sr)AlSiN₃ with an emission wavelength of 660 nm, and the phosphor D1 is (Ca,Sr)AlSiN₃ with an emission wavelength of 720 nm.

The second phosphor comprises: a phosphor C, a phosphor D2, and a phosphor E1. The phosphor C is (Ca,Sr)AlSiN₃ with an emission wavelength of 679 nm, the phosphor D2 is (Ca,Sr)AlSiN₃ with an emission wavelength of 720 nm, and the phosphor E1 is (Ca,Sr)AlSiN₃ with an emission wavelength of 740 nm.

The third phosphor comprises: a phosphor D3, a phosphor E2, and a phosphor F. The phosphor D3 is (Ca,Sr)AlSiN₃ with an emission wavelength of 720 nm, the phosphor E2 is (Ca,Sr)AlSiN₃ with an emission wavelength of 740 nm, and the phosphor F is (Ca,Sr)AlSiN₃ with an emission wavelength of 795 nm.

The mass ratio of the phosphor A, the phosphor B, and the phosphor D1 in the first phosphor, the mass ratio of the phosphor C, the phosphor D2, and the phosphor E1 in the second phosphor, and the mass ratio of the phosphor D3, the phosphor E2, and the phosphor F in the third phosphor contained in the red phosphor compositions of Examples A1 to A9 are shown in Table 1 below.

### Comparative Example A1

This comparative example provides a red phosphor composition, comprising: a phosphor A, the phosphor B, and the phosphor D1. The phosphor A, the phosphor B, and the phosphor D1 in this comparative example are similar to the phosphor A, the phosphor B, and the phosphor D1 in Example A5. The mass ratio of the phosphor A, the phosphor B, and the phosphor D1 in this comparative example is shown in Table 1 below.

### Comparative Example A2

This comparative example provides a red phosphor composition, comprising: a phosphor C, a phosphor D2, and a phosphor E1. The phosphor C, the phosphor D2, and the phosphor E1 in this comparative example are the same as the phosphor C, the phosphor D2, and the phosphor E1 in Example A5. The mass ratio of the phosphor C, the phosphor D2, and the phosphor E1 in this comparative example is shown in Table 1.

### Comparative Example A3

This comparative example provides a red phosphor composition, comprising: a phosphor D3, a phosphor E2, and a phosphor F. The phosphor D3, the phosphor E2, and the phosphor F in this comparative example are the same as the phosphor D3, the phosphor E2, and the phosphor F in Example A5. In this comparative example, the mass ratio of the phosphor D3, the phosphor E2, and the phosphor F is shown in Table 1.

**Table 1 Mass ratio of components of red phosphor composition**

| Mass ratio | Mass ratio of phosphor A (630 nm), phosphor B (660 nm), and phosphor D1 (720 nm) in first phosphor blend A:B:D1 | Mass ratio of phosphor C (679 nm), phosphor D2 (720 nm), and phosphor E1 (740 nm) in second phosphor blend C:D2:E1 | Mass ratio of phosphor D3 (720 nm), phosphor E2 (740 nm), and phosphor F (795 nm) in third phosphor blend D3:E2:F |
|---|---|---|---|
| Example A1 | 3: 3: 5 | 7: 7: 10 | 10: 10: 15 |
| Example A2 | 3: 3: 50 | 7: 7: 50 | 10: 10: 50 |
| Example A3 | 3: 35: 50 | 7: 40: 50 | 10: 40: 50 |
| Example A4 | 25: 35: 50 | 35: 40: 50 | 40: 40: 50 |
| Example A5 | 15: 15: 20 | 20: 20: 25 | 20: 23: 25 |
| Example A6 | 25: 35: 5 | 35: 40: 10 | 40: 40: 15 |
| Example A7 | 25: 3: 50 | 35: 7: 50 | 40: 10: 50 |
| Example A8 | 25: 3: 5 | 35: 7: 10 | 40: 10: 15 |
| Example A9 | 10: 15: 20 | 18: 20: 30 | 25: 25: 27 |
| Comparative Example A1 | 15: 15: 20 | - | - |
| Comparative Example A2 | - | 20: 20: 25 | - |
| Comparative Example A3 | - | - | 20: 23: 25 |

### 2. Examples of red phosphor films

### Example B1 to Example B9

Example B1 to Example B9 provide red phosphor films, respectively. The red phosphor films of Example B1 to Example B9 comprise: a first phosphor film, a second phosphor film, and a third phosphor film, the first phosphor film comprises a film-forming material silica gel and a first phosphor, the second phosphor film comprises a film-forming material silica gel and a second phosphor, and the third phosphor film comprises a film-forming material silica gel, and a third phosphor.

In Example B1, the first phosphor contained in the first phosphor film is the first phosphor in Example A1, the second phosphor contained in the second phosphor film is the second phosphor in Example A1, and the third phosphor contained in the third phosphor film is the third phosphor in Example A1. In Example B2, the first phosphor contained in the first phosphor film is the first phosphor in Example A2, the second phosphor contained in the second phosphor film is the second phosphor in Example A2, and the third phosphor contained in the third phosphor film is the third phosphor in Example A2. This pattern continues accordingly. In Example B9, the first phosphor contained in the first phosphor film is the first phosphor in Example A9, the second phosphor contained in the second phosphor film is the second phosphor in Example A9, and the third phosphor contained in the third phosphor film is the third phosphor in Example A9.

In the red phosphor films of Examples B1 to B9, the film thicknesses of the first phosphor film, the second phosphor film, and the third phosphor film, the concentration of the first phosphor film in the first phosphor film, the concentration of the second phosphor film in the second phosphor film, and the concentration of the third phosphor film in the third phosphor film are detailed in Table 2.

### Comparative Example B1

This comparative example provides a red phosphor film. The red phosphor film of this comparative example is prepared by a film pressing method, with a film thickness of 0.20 mm, including a silica gel and a red phosphor composition, the concentration of the red phosphor composition is 50%, and the red phosphor composition is the red phosphor composition provided by Comparative Example A1.

### Comparative Example B2

This comparative example provides a red phosphor film. The red phosphor film of this comparative example is basically the same as the red phosphor film of Comparative Example B1, except that the red phosphor composition in this comparative example is the red phosphor composition provided by Comparative Example A2.

### Comparative Example B3

This comparative example provides a red phosphor film. The red phosphor film of this comparative example is basically the same as the red phosphor film of Comparative Example B1, except that the red phosphor composition in this comparative example is the red phosphor composition provided by Comparative Example A3.

**Table 2 Thickness of red phosphor film and phosphor concentration parameters**

| Item | Film-formin g metho d | First phosphor film | | Second phosphor film | | Third phosphor film | |
|---|---|---|---|---|---|---|---|
| | | Thickne ss (mm) | Concentrati on (%) | Thickne ss (mm) | Concentrati on (%) | Thickne ss (mm) | Concentrati on (%) |
| Example B1 | Film pressi ng | 0.06 | 40 | 0.06 | 40 | 0.06 | 40 |
| Example B2 | Film pressi ng | 0.10 | 87 | 0.10 | 87 | 0.10 | 87 |
| Example B3 | Film pressi ng | 0.20 | 50 | 0.20 | 50 | 0.20 | 50 |
| Example B4 | Film pressi ng | 0.04 | 75 | 0.04 | 75 | 0.04 | 75 |
| Example B5 | Film pressi ng | 0.10 | 65 | 0.10 | 65 | 0.10 | 65 |
| Example B6 | Spray coatin g | 0.001 | 40 | 0.001 | 30 | 0.001 | 30 |
| Example B7 | Spray coatin g | 0.01 | 87 | 0.01 | 85 | 0.01 | 85 |
| Example B8 | Spray coatin g | 0.006 | 50 | 0.006 | 50 | 0.006 | 50 |
| Example B9 | Spray coatin g | 0.002 | 65 | 0.002 | 65 | 0.002 | 65 |
| Comparati ve Example B1 | Film pressi ng | 0.20 | 50 | - | - | - | - |
| Comparati ve Example B2 | Film pressi ng | 0.20 | 50 | - | - | - | - |
| Comparati ve Example B3 | Film pressi ng | 0.20 | 50 | - | - | | |

### 3. Examples of red LED light source

### Example C1 to Example C9

Example C1 to Example C9 provide red LED light sources, which comprise: a first light-emitting unit, a second light-emitting unit, and a third light-emitting unit.

The first light-emitting unit comprises a first chip and a first phosphor film, the second light-emitting unit comprises a second chip and a second phosphor film, and the third light-emitting unit comprises a third light-emitting chip and a third phosphor film. The emission wavelengths of the first chip, the second chip, and the third chip are shown in Table 3 below.

In Example C1, the first phosphor film is the first phosphor film in Example B1, the second phosphor film is the second phosphor film in Example B1, and the third phosphor film is the third phosphor film in Example B1; in Example C2, the first phosphor film is the first phosphor film in Example B2, the second phosphor film is the second phosphor film in Example B2, and the third phosphor film is the third phosphor film in Example B2; this pattern continues accordingly, in Example C9, the first phosphor film is the first phosphor film in Example B9, the second phosphor film is the second phosphor film in Example B9, and the third phosphor film is the third phosphor film in Example B9.

### Comparative Example C1

This comparative example provides a red LED light source. The red LED light source of this comparative example comprises a light-emitting unit, which comprises a chip and a red phosphor film arranged in the light-emitting path of the chip. The red phosphor film is the red phosphor film provided in Comparative Example B1, and the emission wavelength of the chip is 452 nm.

### Comparative Example C2

This comparative example provides a red LED light source. The red LED light source of this comparative example is basically the same as the red LED light source of Comparative Example C1, except that the red phosphor film of this comparative example is the red phosphor film provided by Comparative Example B2.

### Comparative Example C3

This comparative example provides a red LED light source. The red LED light source of this comparative example is basically the same as the red LED light source of Comparative Example C1, except that the red phosphor film of this comparative example is the red phosphor film provided by Comparative Example B3.

**Table 3 Emission wavelengths of first chip, second chip, and third chip**

| Red LED light source | Emission wavelength (nm) | | |
|---|---|---|---|
| | First chip | Second chip | Third chip |
| Example C1 | 440 | 440 | 440 |
| Example C2 | 460 | 460 | 460 |
| Example C3 | 475 | 475 | 475 |
| Example C4 | 452 | 455 | 458 |
| Example C5 | 452 | 452 | 452 |
| Example C6 | 440 | 440 | 440 |
| Example C7 | 460 | 460 | 460 |
| Example C8 | 475 | 475 | 475 |
| Example C9 | 452 | 452 | 452 |
| Comparative Example C1 | 452 | - | - |
| Comparative Example C2 | 452 | - | - |
| Comparative Example C3 | 452 | - | - |

### Spectral test of the light sources:

The red LED light sources provided by the above-mentioned Examples C1 to C9 and Comparative Examples C1 to C3 were subjected to spectral tests respectively.

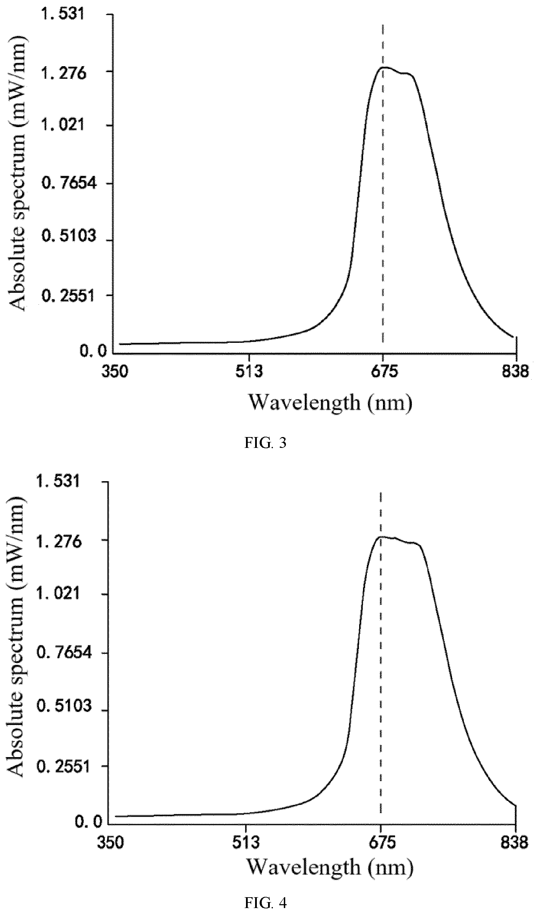

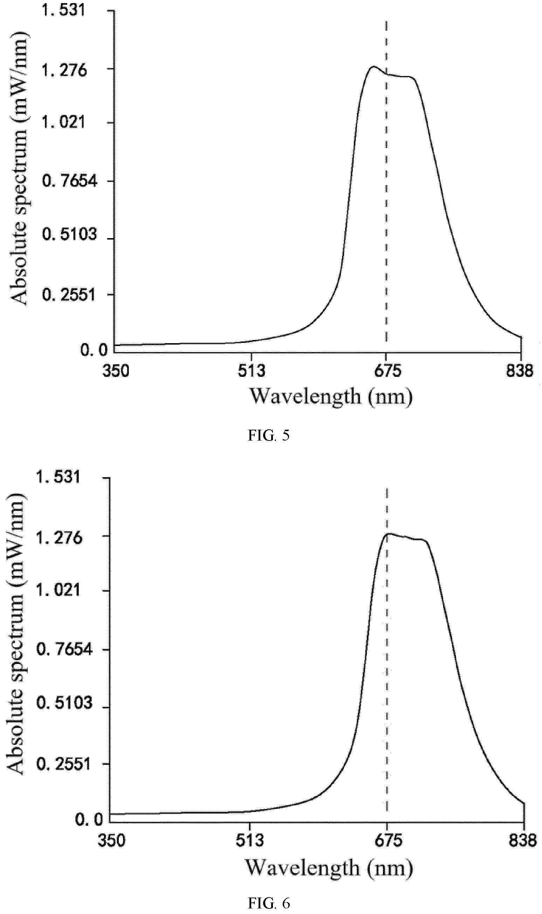

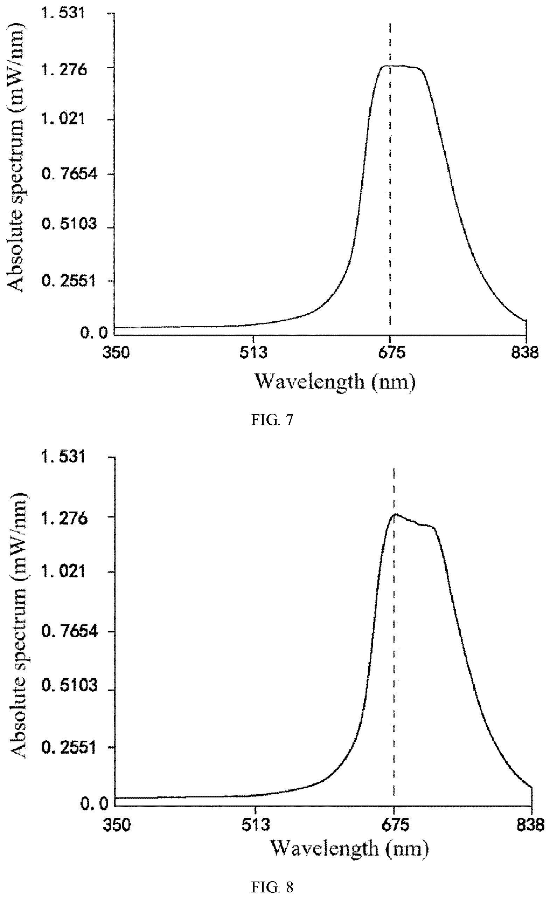

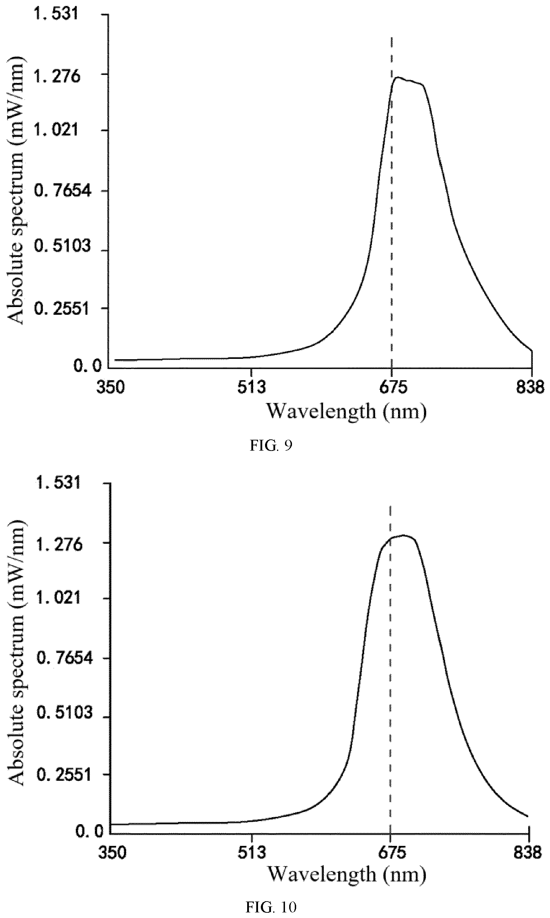

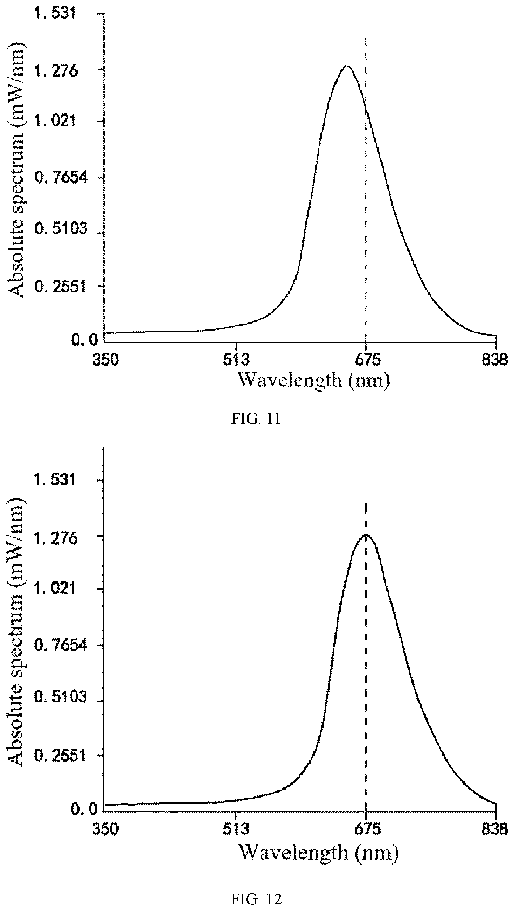

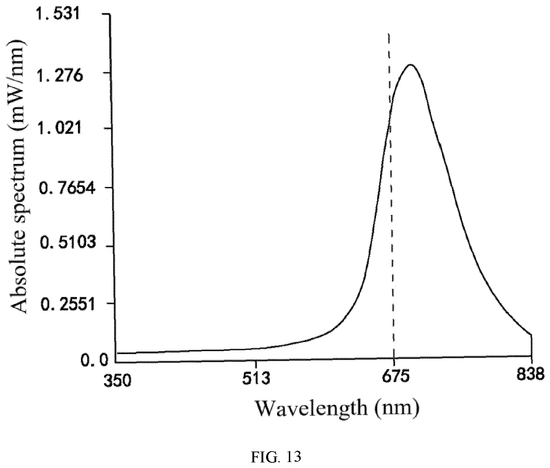

The test results are shown in FIGS. 2-13. The spectrum diagrams of the light sources in Examples C1 to C9 are shown in FIGS. 2-10, and the spectrum diagrams of the light sources in Comparative Examples C1 to C3 are shown in FIGS. 11-13.

As shown in FIGS. 2-10, the red light generated by the red LED light sources provided by Examples C1 to C9 of the present application has a flat peak shape in a wide band before and after the peak, and the absolute spectrum of the red light in this band is close to the maximum absolute spectrum value of the red light (such as the optical power or absolute relative spectrum value of this band is greater than or equal to 80% of the maximum optical power or the maximum absolute relative spectrum value). During physiotherapy, the red light in this band can produce a physiotherapy effect, and this band is an effective band. The effective band of red light physiotherapy produced by the red LED light sources provided by Examples C1 to C9 is wide, and the physiotherapy effect is good.

As shown in FIGS. 11 to 13, the red lights generated by the red LED light sources of Comparative Examples C1 to C3 have a steep peak shape before and after the peak, and the peak is narrow and sharp. As the wavelength increases, the absolute spectral value or optical power of the red light increases rapidly, and the absolute spectral value or optical power decreases rapidly after reaching the maximum value. The maximum absolute spectral value or optical power of the red light is significantly different from the absolute spectral value or optical power at other wavelengths. Only the spectral value or optical power within a very narrow band before and after the peak is similar to the maximum absolute spectral value or optical power. During physiotherapy, only the red light within a very narrow band before and after the peak can produce a physiotherapy effect, and the physiotherapy effect is not good. The effective band of the red light physiotherapy generated by the red LED light sources provided by Comparative Examples C1 to C3 is narrow, and the physiotherapy effect is not good.

## Claims

1. A red phosphor composition, wherein
the red phosphor composition comprises: a first phosphor, a second phosphor, and a third phosphor;
wherein, the first phosphor comprises: a phosphor A, a phosphor B, and a phosphor D1;
the second phosphor comprises: a phosphor C, a phosphor D2, and a phosphor E1;
the third phosphor comprises: a phosphor D3, a phosphor E2, and a phosphor F;
an emission wavelength of the phosphor A is 600 nm to 640 nm;
an emission wavelength of the phosphor B is 650 nm to 660 nm;
an emission wavelength of the phosphor C is 670 nm to 700 nm;
emission wavelengths of the phosphor D1, the phosphor D2, and the phosphor D3 are independently 710 nm to 730 nm;
emission wavelengths of the phosphor E1, the phosphor E2, and the phosphor F are independently greater than 730 nm and less than or equal to 800 nm;
in the first phosphor, a mass ratio of the phosphor A, the phosphor B, and the phosphor D1 is (3 to 25) : (3 to 35) : (5 to 50);
in the second phosphor, a mass ratio of the phosphor C, the phosphor D2, and the phosphor E1 is (7 to 35) : (7 to 40) : (10 to 50);
in the third phosphor, a mass ratio of the phosphor D3, the phosphor E2, and the phosphor F is (10 to 40) : (10 to 40) : (15 to 50);
particle sizes of the first phosphor, the second phosphor, and the third phosphor are independently less than or equal to 50 µm; and/or
at least one of the first phosphor, the second phosphor, and the third phosphor is provided separately from other two phosphors.

2. A red phosphor film, wherein the red phosphor film comprises: a first phosphor film, a second phosphor film, and a third phosphor film; wherein:
a material of the first phosphor film comprises: a first film-forming material, and the first phosphor contained in the red phosphor composition of claim 1 and dispersed in the first film-forming material;
a material of the second phosphor film comprises: a second film-forming material, and a second phosphor contained in the red phosphor composition of claim 1 and dispersed in the second film-forming material; and
a material of the third phosphor film comprises: a third film-forming material, and a third phosphor contained in the red phosphor composition of claim 1 and dispersed in the third film-forming material.

3. The red phosphor film of claim 2, wherein in the first phosphor film, the first phosphor accounts for 40% to 87% of a total mass of the first phosphor and the first film-forming material; and/or
in the second phosphor film, the second phosphor accounts for 30% to 87% of a total mass of the second phosphor and the second film-forming material; and/or
in the third phosphor film, the third phosphor accounts for 30% to 87% of a total mass of the third phosphor and the third film-forming material; and/or
at least one of the first phosphor film, the second phosphor film, and the third phosphor film is provided separately from other two phosphor films.

4. The red phosphor film of claim 2 or 3, wherein
any one of the first phosphor film, the second phosphor film, and the third phosphor film is prepared by a film pressing method; and/or
a film thickness of any one of the first phosphor film, the second phosphor film, and the third phosphor film is 0.06 mm to 0.6 mm.

5. The red phosphor film according to claim 2 or 3, wherein
any one of the first phosphor film, the second phosphor film, and the third phosphor film is prepared by a spray coating method; and/or
a film thickness of any one of the first phosphor film, the second phosphor film, and the third phosphor film is 0.001 mm to 0.01 mm.

6. A red LED light source, comprising: a light-emitting unit, the light-emitting unit comprising: a chip, and a red phosphor film arranged on an optical path of the chip, and the red phosphor film is the red phosphor film according to any one of claims 2-5.

7. The red LED light source according to claim 6, wherein the red LED light source comprises the following three light-emitting units:
a first light-emitting unit, wherein the first light-emitting unit comprises: a first chip, and the first phosphor film arranged on an optical path of the first chip;
a second light-emitting unit, wherein the second light-emitting unit comprises: a second chip, and the second phosphor film arranged on an optical path of the second chip;
a third light-emitting unit, wherein the third light-emitting unit comprises: a third chip, and the third phosphor film arranged on an optical path of the third chip.

8. The red LED light source of claim 7, wherein an emission wavelength of any one of the first chip, the second chip, and the third chip is 440 nm to 475 nm.

9. The red LED light source of claim 8, wherein
in the first light-emitting unit, the emission wavelength of the first chip is 440 nm to 460 nm, and a mass ratio of the phosphor A, the phosphor B, and the phosphor D1 in the first phosphor contained in the first phosphor film is (5 to 25) : (5 to 25) : (10 to 40), and the first phosphor accounts for 50% to 80% of a total mass of the first phosphor and the first film-forming material; and/or
in the second light-emitting unit, the emission wavelength of the second chip is 440 nm to 460 nm, and the mass ratio of the phosphor C, the phosphor D2, and the phosphor E1 in the second phosphor contained in the second phosphor film is (10 to 30) : (10 to 35) : (15 to 40), and the second phosphor accounts for 50% to 80% of a total mass of the second phosphor and the second film-forming material; and/or
in the third light-emitting unit, the emission wavelength of the third chip is 440 nm to 460 nm, and the mass ratio of the phosphor D3, the phosphor E2, and the phosphor F in the third phosphor contained in the third phosphor film is (12 to 35) : (12 to 35) : (15 to 40), and the second phosphor accounts for 50% to 80% of a total mass of the third phosphor and the third film-forming material.
